# EUROPEAN PATENT APPLICATION

(11) **EP 4 496 131 A1**
(43) Date of publication of application: **22.01.2025**
(21) Application number: 23186538.7
(22) Date of filing: 19.07.2023
(51) Int. Cl.: H01R 13/08, H01R 13/24, H01R 12/73, H05K 3/36

(54) **INTEGRAL CYLINDER BODY AND SPRING-LOADED CONTACT**

(71) Applicant: PRECI-DIP SA, 2800 Delémont (CH)
(72) Inventor: Tronel, Tanguy, 2800 Delémont (CH); Streissel, Eric, 2800 Delémont (CH); Wilhite, Matthew, Dublin, K36 E088 (IE)
(74) Representative: Novagraaf International SA

(57) **Abstract**

A cylinder body for a spring-loaded contact including the cylinder body, a coil spring and a piston body, the cylinder body comprising:
- a base portion adapted to be in contact with the coil spring and to be electrically connected with an external part,
- a clipping portion integral with the base portion and adapted to mate with the piston body.

## Description

The present invention relates to a cylinder body and a spring-loaded contact for electrical connection.

Spring-loaded contacts, also referred to as pogo pins, are integral components in an array of technical fields subjected to significant constraints, including the aerospace, automotive, space, and military industries. These domains necessitate the implementation of reliable and durable electrical connections to maintain the proper functioning of complex systems and ensure the safety of their users. The spring-loaded contact, which generally incorporates a plunger, a barrel, and a spring, provides such a reliable electrical connection, facilitating the transmission of signals and power between two mating surfaces. The inherent mechanical compliance of these contacts allows for a degree of misalignment and movement between connected components, thereby ensuring a stable connection even in the face of environmental factors such as vibrations and thermal expansion.

In addition to their compactness and reliability, spring-loaded contacts may endure the rigorous operating conditions encountered in industries such as automotive and military applications. These contacts must withstand a wide range of environmental conditions, including temperature extremes, humidity, corrosion, and exposure to various chemicals. The robustness of spring-loaded contacts should ensure a long-lasting electrical connection, minimizing the risk of system failure and reducing the need for frequent maintenance or replacement. The resilience of these contacts should enhance the overall reliability and longevity of the systems in which they are employed, ultimately contributing to the safety and dependability of vehicles, aircraft, spacecraft, and military equipment.

As miniaturization trends continue to pervade various technical fields, the demand for low-profile electrical connections has surged. Although the compact design of spring-loaded contact enables them to accommodate space constraints without compromising the integrity of the electrical connection, there is still a need to propose spring-loaded contact having a low-profile, i.e. a limited height while providing an extended spring stroke to support severe mechanical constraints. A reduced-height contact is thus needed for streamlined and space-efficient designs in industries such as aviation and space exploration, where every millimetre counts. Furthermore, a low-profile contact minimizes the risk of mechanical interference, ensuring the uninterrupted operation of intricate electronic systems in these demanding environments.

Cost reduction is a crucial consideration across all technical fields, and the implementation of spring-loaded contacts can contribute to achieving this objective. By providing reliable and long-lasting electrical connections, these contacts reduce the need for frequent repairs and replacements, thereby minimizing associated costs. Additionally, the use of low-profile contacts allows for more efficient designs that require fewer materials and resources, leading to further cost savings. However, low-profile spring-loaded contact may be difficult to manufacture and assemble.

WO2022/223474 discloses a piston assembly and a spring-loaded contact having a low profile. However, this spring-loaded contact requires a minimal width or diameter to ensure a sufficient coil spring force. For this reason, this spring-loaded contact cannot be used in applications requiring several spring-loaded contacts in a tiny space. In addition, this spring-loaded contact requires an open end, which is to be avoided for applications in which foreign material may penetrate the spring-loaded contact.

An object of the disclosure is thus to provide a reliable spring-loaded contact having a low profile and a small diameter.

The present disclosure concerns a cylinder body for a spring-loaded contact including the cylinder body, a coil spring and a piston body, the cylinder body comprising:
- a base portion adapted to be in contact with the coil spring and to be electrically connected with an external part,
- a clipping portion integral with the base portion and adapted to mate with the piston body.

The clipping portion is thus intended to ensure an electrical connection through mating with the piston body, which may be moveable relative to the cylinder body. A further electrical connection may be performed directly or indirectly with the external part. For example, the base portion may be adapted to be received in a housing or an insulating case.

The cylinder body allows for the manufacturing of a small diameter spring-loaded contact, allowing a limited pitch between the centres of two neighbours spring-loaded contacts, such as 2 mm or even 1 mm. Consequently, a diameter of the cylinder body may be below 2 mm, for example below 1 mm. In addition, the height of a spring-loaded contact including the cylinder body may be kept small, for example to a total height of 10 mm or less and preferably 5 mm or less. Finally, a spring-loaded contact including the cylinder body provides a reliable electrical connection overtime and a good resistance to wear, to shocks and vibrations and can be manufactured with closed ends.

Advantageously, the clipping portion includes at least two beams extending from the base portion and preferably three, four, five or six beams and at most preferably four beams. Thanks to the beams, the clipping portion can reliably mate with the piston body. For example, the beams have a limited flexibility which allows a limited pressure to be applied to the piston body and therefore a suitable fit and/or movement of the piston body within the clip portion. The beams thus allow for a safe and reliable connection with the piston body.

Advantageously, the two beams are titled toward a longitudinal axis of the cylinder body from an angle below 10°, preferably below 6° and at most preferably below 4°, with regard to the longitudinal axis of the cylinder body. For example, the longitudinal axis may be confused with a longitudinal axis of the clipping portion, of the piston body and/or of the spring-loaded contact. This angle allows to apply a force on the piston body and to obtain mating on an area at the extremity of the beams, thus contributing to reducing the total height of the spring-loaded contact.

Advantageously, the clipping portion extends from a base wall of the base portion. The longitudinal axis of the cylinder body may be orthogonal to the base wall of the base portion from which the clipping portion extends. The base wall may include a circumferential surface adapted to receive the coil spring. The circumferential surface may be continuous and flat or alternatively may include a groove or a circumferential wall, in order to improve or ensure the contact or mechanical connection with the coil spring. A central portion of the base wall within the clipping portion may be flat and is preferably at least continuous, without any through hole, in order to prevent any ingress of foreign material. Such a clipping portion may be efficiently produced by screw machining.

Advantageously, the base portion includes a contact surface adapted for an electrical connection with the external part. The contact surface may differ from the base wall. Preferably, the contact surface is not flat, which allows a simpler assembly of the spring-loaded contact within an electronic system.

Advantageously, the contact surface of the base portion is opposite with regard to the clipping portion and preferably includes a connection pin, which allows facilitating assembly of the spring-loaded contact and facilitating mounting of the spring-loaded contact into an electrical or electronic system.

The present disclosure further relates to spring-loaded contact including:
- a cylinder body as described above;
- a piston body adapted to be electrically connected with another external part and including a shaft extending from the piston body,
wherein the shaft is mated with the clipping portion.

An electrical connection through the spring-loaded contact may thus be obtained by the mating of the shaft with the clipping portion, and the electrical connection may be maintained even in the case of a relative movement of the cylinder body with regard to the piston body. For example, a spring-loaded contact may include more than one cylinder body and piston body.

Advantageously, the piston body and the cylinder body are moveable in translation and/or in rotation one with regard to the other. Alternatively, the spring-loaded contact only allows a translation. Preferably, a coil spring is arranged between the base portion of the piston body and the base portion of the cylinder body.

Advantageously, the spring-loaded contact includes a coil spring surrounding the clipping portion and the shaft, the piston body and the cylinder body being moveable in translation one with regard to the other and defining:
- an extended position in which the piston body is at a first distance of the cylinder body, and
- a compressed position in which the piston body is at a second distance, smaller than the first distance, of the cylinder body.

10 % to 15% of the shaft length may be accommodated in the clipping portion in the extended position and 80 to 95% of the shaft length may be accommodated in the clipping portion in the compressed position.

Advantageously, the contact surface of the piston body is opposite with regard to the shaft and may include a piston connection pin.

Advantageously, the spring-loaded contact includes a case accommodating the cylinder body and the piston body and defining a first opening allowing a connection of the base portion with the external part and a second opening allowing a connection of the piston body with the another external part.

Preferably, one of the cylinder body and the piston body is fixed with regard to the case, which allows to simplify assembling the spring-loaded contact. Alternatively, both the cylinder body and the piston body are moveable with regard to the insulating case.

The disclosure further relates to a cylinder body for a spring-loaded contact including the cylinder body, a coil spring and a piston body, the cylinder body comprising:
- a base portion including a solid base wall and adapted to be in contact with the coil spring and to be electrically connected with an external part,
- a clipping portion extending from the solid base wall, integral with the base portion and adapted to mate with the piston body.

The disclosure further relates to a cylinder body for a spring-loaded contact including the cylinder body, a coil spring and a piston body, the cylinder body comprising:
- a base portion adapted to be in direct contact with the coil spring and to be electrically connected with an external part,
- a clipping portion extending from the base portion, integral with the base portion and adapted to mate with the piston body.

The above advantageous features also apply to these cylinder bodies.

The disclosure further relates to a spring-loaded contact, including any of the above-described cylinder bodies.

The disclosure further relates to an electrical or electronic system, including a spring-loaded contact as disclosed above. Preferably, a plurality of spring-loaded contacts are provided to transmit electrical power and/or signals between distant electronic elements.

The disclosure further relates to a manufacturing method of a spring-loaded contact as disclosed above, including:
- Providing the cylinder body, the piston body, the coil spring and the case, as described above, the case having a first opening:
- Introducing one of the piston body and the cylinder body in the case through the first opening
- Introducing the coil spring in the case through the first opening;
- Introducing the other of the piston body and the cylinder body in the case through the first opening and closing the first opening with the other of the piston body and the cylinder body.

For example, the other of the piston body and the cylinder body is press-fit in the first opening, preferably the cylinder body. The case may be an insulating case.

The disclosure further relates to a manufacturing method of a spring-loaded contact as disclosed above, including:
- Providing the cylinder body, the piston body and the coil spring as described above;
- Providing a case including a first half case and a second half case , wherein each of the first half case and the second half case comprises a first opening
- Introducing one of the piston body and the cylinder body in the first half case of the case through the first opening;
- Introducing the coil spring in the first half case of the case through the first opening;
- Introducing the other of the piston body and the cylinder body in the second half case through the first opening of the second part,
- Assembling the case by connecting the first opening of the first half case with the first opening of the second half case.

The disclosure further relates to the use of a spring-loaded contact according to any of the above aspects in order to transmit electrical power or electrical signals in an electrical system or electronic system.

Other features and advantages of the present invention will appear more clearly from the following detailed description of particular non-limiting examples of the invention, illustrated by the appended drawings where:
Figure 1 is a partial exploded side view of a spring-loaded contact, according to an embodiment of the disclosure.
Figure 2 represents a side view of a cylinder body of the spring-loaded contact, according to figure 1.
Figure 3 represents a side view of a piston body of the spring-loaded contact of figure 1.
Figures 4A and 4B represent respectively a side view and a cut view of the partial spring-loaded contact of figure 1 in an assembled configuration.
Figure 5 represents a partial, perspective view of another spring-loaded contact.
Figures 6A and 6B represent a full cut-view of the spring-loaded contact of figures 1 and 4A-4B in an extended position and in a compressed position, respectively.
Figures 7A and 7B represent a full cut-view and a three-quarter view of another spring-loaded contact.

The spring-loaded contact is intended to transmit power and/or signal in any electrical or electronic equipment, in particular in the fields of automotive, space, aeronautics or military.

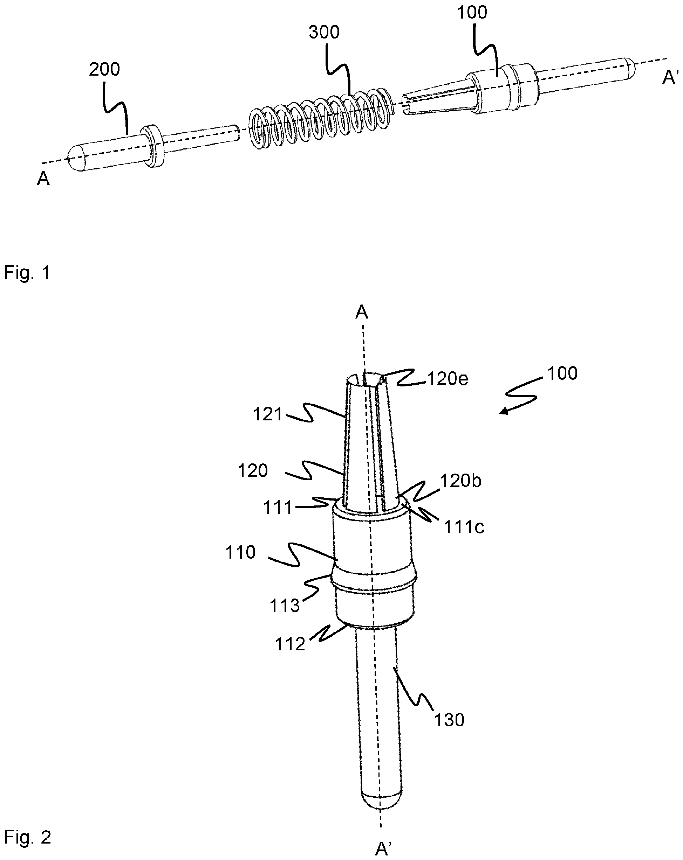

With reference to Fig. 1, a spring-loaded contact according to the disclosure includes a cylinder body 100, a piston body 200, a coil spring 300 and a case (not shown). The cylinder body 100, the piston body 200 and the coil spring are to be substantially aligned on a longitudinal axis A-A' in an assembled position.

With reference to Fig. 2, the cylinder body 100 includes a base portion 110 having a base wall 111 and a clipping portion 120 extending from the base wall 111. The clipping portion 120 includes at least two beams 121 and preferably four beams 121 as visible in Fig. 2. Five or six beams may also be considered. The beams 121 may extend from the base wall 121 in a direction orthogonal to the base wall 111 i.e. somehow aligned with the longitudinal axis of the cylinder portion 100 (i.e. the longitudinal axis A-A'). Preferably, the clipping portion 120 may have a conical shape: the beams 121 may be tilted with regard to a strict orthogonal axis and toward the longitudinal axis A-A'. For example, the beams may have a tilt angle of at most 15°, preferably at most 10 °, again preferably at most 6° or at most 4°, with regard to the longitudinal axis A-A'

Consequently, as visible in Fig. 2, the diameter of an inside space of the clipping portion 120 i.e. the space delimited by the beams 121, may be reduced from a base portion 120b of the clipping portion 120 on the base wall 111 toward the free extremity 120e of the clipping portion 120. The thickness of the beams 121 may be reduced from the base portion 120b toward the free extremity 120e, for example to provide flexibility to the beams. A chamfer may be provided on the beams 121 on the free extremity 120e, for example to simplify manufacturing and/or assembling of the spring-loaded contact.

The base wall 111 is preferably a flat and solid surface as visible on Figs. 1-2 but may be curved or hemispherical surface in other embodiments not shown. In addition, the base wall 111 preferably includes a circumferential surface 111c around the base portion 120b of the clipping portion 120. This circumferential surface 111c is intended to receive an extremity of the coil spring 300 and may be flat as shown in Figs. 1-2 or may alternatively include a groove or a peripheral wall (not shown).

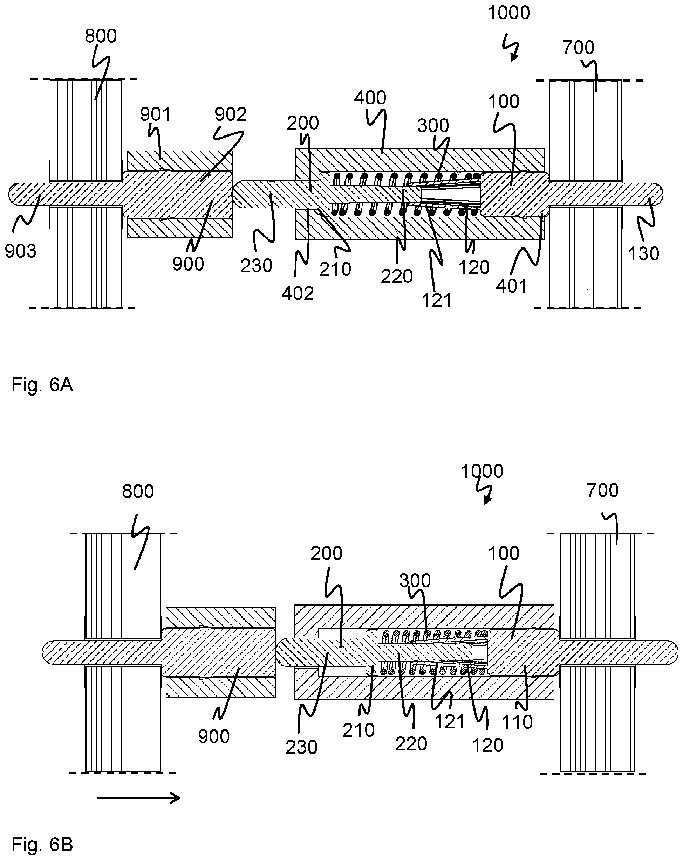

The base portion 110 may have a contact surface 112, for example opposite to the base wall 111 and adapted to connect the cylinder body 100 with an external part (visible in Figs. 6A-6B). Further, a peripheral wall may connect the contact surface 112 and the base wall 111, for example through respective chamfers or bevels. A circumferential bulge 113 may be provided on the peripheral wall for assembly purposes. Alternatively or in combination, any other assembly features may be provided on the base portion 110, in particular on the peripheral wall. These assembly features include but are not limited to one or more grooves, protrusions, recesses or bulges, with any shape known in the art.

A connection pin 130 may protrude from the contact surface 112, in order to allow connecting the contact surface 112 with the external part. For example, the connection pin 130 may have an elongated shape along the longitudinal axis A-A'. The connection pin may thus extend in a direction substantially opposite to that of the clipping portion 120. The connection pin 130 may be inserted though or in the external part, for example through a printed-circuit board. Alternatively, the contact surface 112 may be a bare surface or may receive any connection feature such as one or more of a connection hole, a connection groove and a connection tooth.

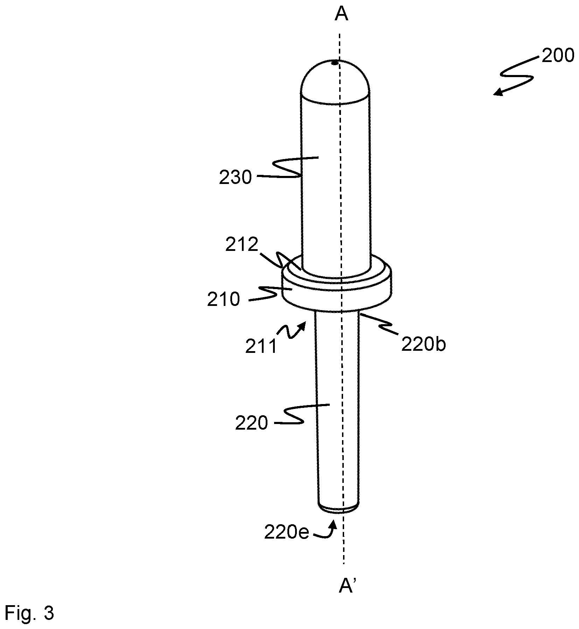

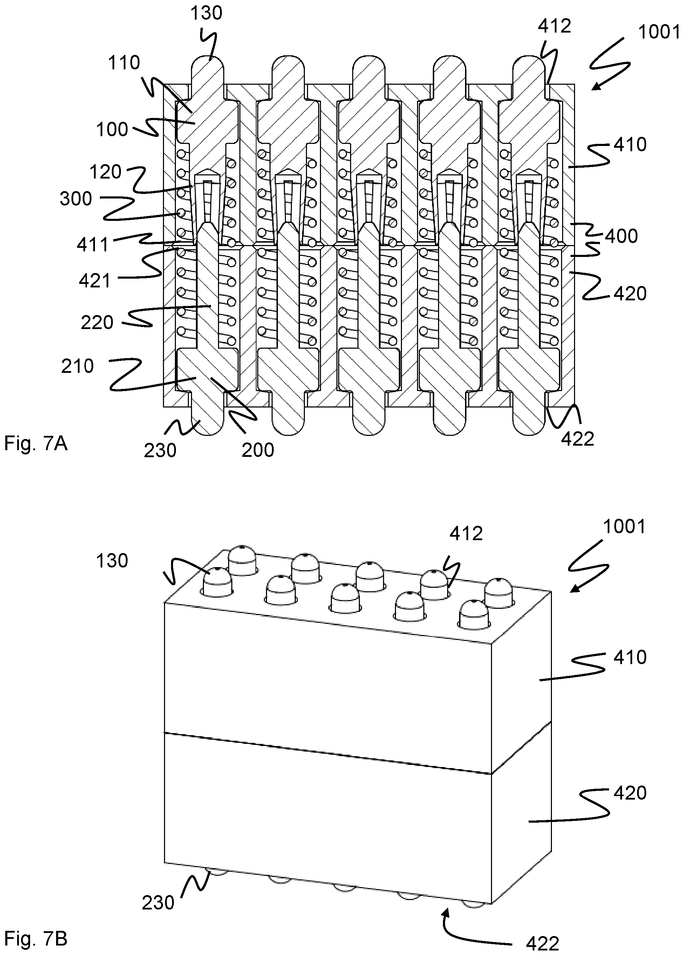

With reference to Fig. 3, the piston body 200 includes a piston base 210 comprising a base surface 211 and a piston contact surface 212. A shaft 220 extends from the base surface 211 along the longitudinal axis A-A'. In Fig. 3 the shaft 220 is a truncated cone or frustum, i.e. a cone with a flat extremity 220e, which is easier to manufacture and to assemble with the piston body 100. The flat extremity 220e has preferably a bevelled circumferential surface. Alternatively, the shaft 220 may have a rounded extremity and/or may be or may include a cylinder (see Fig. 7A).

The diameter of a shaft base portion 220b of the shaft 220 may be smaller than the diameter of the base surface 211. The remaining surface of the base surface 211, i.e. the circumferential surface around the shaft base portion 220b (not visible in Fig. 3) may receive another extremity of the coil spring 300. For example, the circumferential surface may be flat or may have a groove or a circumferential wall. The piston contact surface 212 may be provided with a piston connection pin 230, similarly to the contact surface 112 of the cylinder body 100, to allow connection with another external part (not shown in Fig. 3, see Figs. 6A-6B).

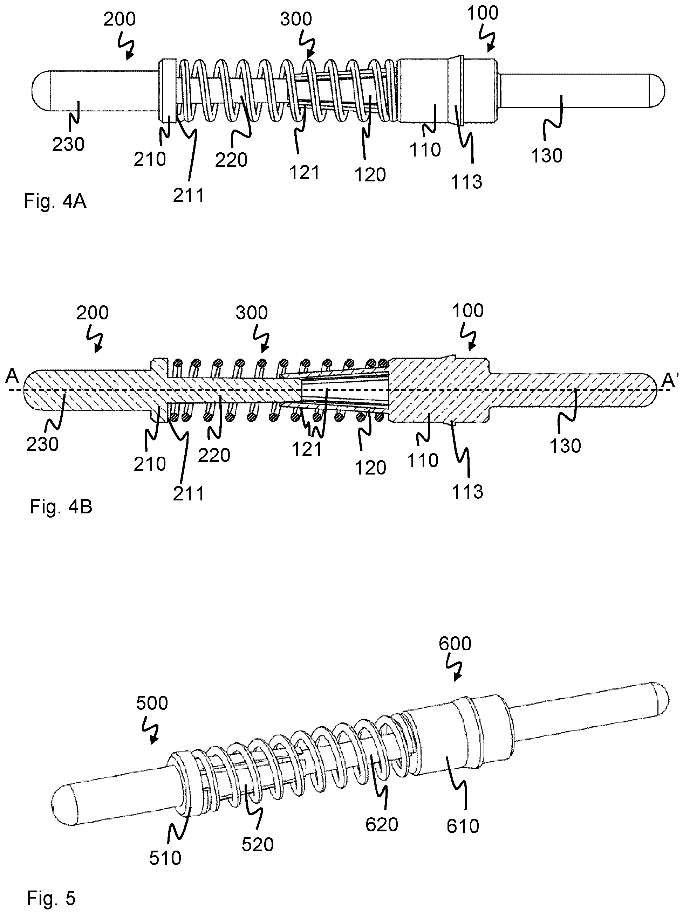

With reference to Figs. 4a and 4B, the cylinder body 100, the piston body 200 and the coil spring 300 are shown in an assembled configuration, without any case. The shaft 220 is partially accommodated within the beams 121 of the clipping portion 120, and the beams 121 apply a slight pressure on the surface of the shaft 220. A mechanical and electrical contact thus occurs at least between a surface at or near to free extremity 120e of the clipping portion 120 and the circumferential surface of the shaft 220, allowing transmission of an electric current between the cylinder body 100 and the piston body 200.

A relative movement of the cylinder body 100 with regard to the piston body 200 relates to a movement of the shaft 220 within the beams 121, which may slightly flex due to this movement. A mechanical and electrical contact between the cylinder body 100 and the piston body 200 is thus maintained regardless of the nature of the movement. Consequently, the external part connected to the contact surface 112 of the cylinder body 100 may move relative to the another external part connected to the piston contact surface 212, for example due to vibration or shocks.

The movement may consist in a translation along the longitudinal axis A-A'. However, a limited nonalignment of one of the piston body 200 or the cylinder body 100 may be allowed for example with a tilt angle of 1 to 3 degrees with regard to the longitudinal axis A-A'. A relative rotation of the piston body 200 and the cylinder body 100 may also be allowed. The coil spring 300 is assembled between the base surface 211 and the base wall 111 of the piston body 200 and the cylinder body 100, respectively and counters any pressure applied on the piston body 200 or on the cylinder body 100.

Fig. 5 relates to a different embodiment with regard to the first embodiment of Figs. 1-4B. In this embodiment, the clipping portion and the shaft are inverted. In other words, the cylinder body 500 includes a clipping portion 520 extending from a base portion 510 similar or identical to the piston base 210 of the piston body 200. The piston body 600 includes a shaft 620 extending from a piston base 610 identical to the base portion 110 of the cylinder body 100.

With reference to Figs. 6A-6B, a spring-loaded contact 1000 is shown in an assembled configuration. The spring-loaded contact 1000 includes the cylinder body 100, the piston body 200 and the coil spring 300 of Figs. 4A-4B, enclosed in a case such as an insulating case 400. The insulating case 400 may have a barrel shape with a central free space accommodating the cylinder body 100, the piston body 200 and the coil spring 300.

The cylinder body 100 may be fixed to the insulating case 400, for example may be press-fit by the circumferential bulge 113 and/or soldered to the insulating case 400. The piston body 200 may be moveable with regard to the insulating case 400, in particular in translation and/or in rotation. The piston body 200 may have a limited tilt with regard to the insulating case 400, as discussed above.

In a spring-loaded contact (not shown) according to the embodiment of Fig. 5, the cylinder body 500 may be moveable with regard to the case and the piston body 600 may be fixed to the case. In another embodiment, both the piston body and the cylinder body may be moveable with regard to the case and the case may be closed by a nut, preventing the piston body and/or the cylinder body to escape from the central free space.

In Figs. 6A-6B, the insulating case comprises a large opening or first opening 401 allowing connection of the cylinder body 100 and a second opening 402 allowing connection of the piston body 200. In the embodiment of Figs. 6A-6B, the first opening 401 has a diameter or width adapted to receive the base portion 110 of the cylinder body 100. In other words, the base portion 110 may close the central free space of the insulating case 400. The connection pin 130 may thus protrude from the insulating case 400 and for example, may be mated with a first PCB 700, as the external part. For example, the first PCB 700 may have one or several traces to electrically connect the connection pin 130 with one or more electronic components (not shown). In view of the above, the cylinder body 100, the insulating case 400 and the first PCB 700 may be in a fixed mechanical connection. The connection pin 130 may have a height or length along the longitudinal axis A-A' of less than 2 mm.

Opposite to the first opening 401, the second opening 402 may have a diameter or width allowing the piston connection pin 230 of the piston body 200 to extend from the insulating case 400. The piston body 200 is moveable with regard to the insulating case 400 so that the piston connection pin 230 is moveable through and inside the second opening 402. Since the diameter or width of the second opening 402 is smaller than that of the piston base 210 of the piston body 200, the cylinder body 200 is maintained inside the central free space of the insulating case 400, and the piston contact surface 212 around the shaft base portion 220b may be in contact or in abutment with an internal wall of the insulating case 400, as visible in Fig. 6A.

The piston connection pin 230 may be in electrical contact with the another external part. The another external part may be a second PCB 800 provided for example with a pad connector 900 having an insulating sheath 901 and a central conductor 902. The pad connector 900 may comprise a conductor pin 903 plugged in the second PCB 800 and electrically connected to electronic components through traces. An extremity of the pad connector 900 includes no insulating sheath 901 so that the central conductor 902 can contact the piston conduction pin 230 of the piston body 200 to allow an electrical connection.

In Fig. 6A, the spring-loaded contact is in an extended position, in which the coil spring 300 is extended to a maximum length and the piston body 200 is located the furthest from the fixed cylinder body 100. In this extended position, the shaft 220 mates with the clipping portion 120 and a limited length of the shaft 220 is accommodated within the beams 121 of the clipping portion 120. For example, this limited length may be 5 to 30% of the shaft length, preferably 8 to 25% and for example 10 to 20% or 10 to 15%. Due to the accommodation of the distal extremity of the shaft 220 within the cylinder body 100 and the contact with the clipping portion 120, an electrical connection may be ensured from the first PCB 700 to the second PCB 800 through the spring-loaded contact 1000.

In Fig. 6B, the second PCB 800 has moved toward the first PCB 700, for example due to an external shock, acceleration, deceleration or due to vibrations and the spring-loaded contact 1000 is now in a compressed position. The pad connector 900 has pushed the piston body 200 toward the cylinder body 100. The shaft 220 is deeper inside the clipping portion 120 and the coil spring 300 is now in a compressed state. The piston base 210 is now in a position closer to the base portion 110. The beams 121 of the cylinder body 100 are still in electrical contact with the shaft 220 and an electrical connection is maintained between the first PCB 700 and the second PCB 800 through the spring-loaded contact 1000.

At the end of the external event causing the compressed position of the spring-loaded contact 1000, the second PCB 800 may move back from the position visible in Fig. 6B to the position visible in Fig. 6A and the coil spring 300 may extend and push the piston body 200 toward the original position of Fig. 6A.

The cylinder body can be manufactured by bar turning or screw machining, in order to dig a central lumen in a piece of appropriate metal, such as iron, copper or an alloy. The beams can then be cut from the peripheral wall of the central lumen and then tilted toward the longitudinal axis by a mechanical pressure, for example with a conical counter-shape. If required, the beams may be heated during this step. The bulge and the connection pin may also be obtained by screw machining. A plating step may be performed, for example to apply a gold plating on the cylinder body or at least on the beams and/or on the connection pin, if required.

Similarly, the piston body 200 may be manufactured by screw-machining a piece of metal in the desired shape. A coating may be added such as a gold coating, preferably on the shaft 220 and/or on the piston connection pin 230. The insulated case 400 may be obtained by moulding an insulating polymer or composite. Alternatively, a metallic case may be obtained by screw machining.

A manufacturing or assembling method of the spring-loaded contact may be as follows. The cylinder body 100, the piston body 200, the coil spring 300 and the insulating case 400 may be provided. The cylinder body 100 may be introduced inside the central free space of the insulating case 400 by the first opening. The coil spring 300 may then be aligned on the longitudinal axis A-A' and introduced in the central free space toward the piston body 200, so that an extremity of the coil spring 300 contacts the base surface 211. The cylinder body 100 may then be aligned on the longitudinal axis A-A' and press-fit into the first opening 401 of the insulating case 400. An additional welding or gluing step may be optionally considered. The above manufacturing method allows to efficiently provide the present spring-loaded contact.

One or more spring-loaded contacts may then be integrated to an electronic or electrical system in order to transmit power and/or signals, such as high-frequency or high-bitrate signals.

With reference to Fig. 7A, and 7B, a spring-loaded contact 1001 may include an insulating case 400 including a first half case 410 and a second half case 420. The first half case 410 may accommodate one or a plurality of cylinder bodies 100 and the second half case 420 may accommodate one or a plurality of piston bodies 200. A plurality of coil spring 300 are accommodated in the first half case 410 and the second half case 420, between the base portions 110 and the piston bases 210, as disclosed above.

The first half case 410 has an assembly surface provided with a plurality of large opening or first openings 411 and an external surface provided with a plurality of small openings or second openings 412, from which the connection pins 130 may protrude in order to allow an electrical contact with the external part. Each first opening 411 is provided in regard of a second opening 412, i.e. aligned on the same longitudinal axis. The first and second opening may have the same diameter.

The second half case 420 is similar to the first surface with an assembly surface provided with a plurality of first openings 421 and an external surface with a plurality of second openings 422 from which a plurality of piston connection pins 230 may protrude to allow an electrical contact with the another external part. For example, the first half case 410 and the second half case 420 may have the same height. Preferably, one of the first half case and the second half case has a larger height (not shown).

Both the cylinder bodies 100 and the piston bodies 200 are moveable with regard to the insulating case 400, so that an electrical connection with a high level of reliability may be ensured despite any movement of the external part and/or the another external part. In addition, the plurality of cylinder bodies and piston bodies also contributes to the reliability of the electrical connection.

As a manufacturing method, the cylinder bodies 100 may be introduced in the first half case 410 through the first openings 411. Similarly, the piston bodies 200 may be introduced in the second half case 420 through the first openings 421. The coil springs may be provided to one of the cylinder bodies 100 and the piston bodies 200. In the case one of the first part and the second part has a larger height, the coil springs may be introduced in this one of the first part and the second part having the larger height.

The first half case 410 is then assembled to the second half case 420 so that the first openings 411 of the first half case 410 communicate with the first openings 421 of the second half case 420. The shafts 210 are thus mated with the clipping portions 110 and an assembled insulating case 400 is thus obtained. For example, the assembly may be performed horizontally. The first half case 410 and the second half case 420 may be assembled together by any known means such as screws, rivets, welding, gluing, etc.

The present disclosure does not limit the scope of the invention which may include any alternative or improvement available to the skilled person. In particular, the features and elements of the above-described spring-loaded contacts may be exchanged. In addition, all the elements may have a circular symmetry around the longitudinal axis A-A'. The different elements of the spring-loaded contact according to the present disclosure are not limited to a circular or cylindrical shape but may have any available shape such a square, rectangular or oval shape. All the embodiments may be realized as a multicontact spring-loaded contact as visible in Figs. 7A-7B or as a single contact spring-loaded contact as visible in Figs. 6A-6B.

### Reference Numerals

100, 500 cylinder body
110, 510 base portion
111 base wall
   111c circumferential surface
112 contact surface
113 circumferential bulge
120, 520 clipping portion
   120b base portion
   120e free extremity
121 beams
130 connection pin
200, 600 piston body
210, 610 piston base
211 base surface
212 piston contact surface
220, 620 shaft
   220b shaft base portion
   220e flat extremity
230 piston connection pin
300 coil spring
400 insulating case
401, 411, 421 first opening
402, 412, 422 second opening
410 first half case
420 second half case
700 first PCB
800 second PCB
900 pad connector
901 insulating sheath
902 central conductor
903 conductor pin
1000, 1001 spring-loaded contact

## Claims

1. A cylinder body for a spring-loaded contact including the cylinder body, a coil spring and a piston body, the cylinder body comprising:
- a base portion adapted to be in contact with the coil spring and to be electrically connected with an external part,
- a clipping portion integral with the base portion and adapted to mate with the piston body.

2. The cylinder body of claim 1, wherein the clipping portion includes at least two beams extending from the base portion and preferably three or four beams.

3. The cylinder body of claim 2, wherein the two beams are titled toward a longitudinal axis of the cylinder body from an angle below 10° with regard to the longitudinal axis.

4. The cylinder body of any of claims 1 to 3, wherein the clipping portion extends from a base wall of the base portion, the base wall including a circumferential surface adapted to receive the coil spring.

5. The cylinder body of any of claims 1 to 4, wherein the base portion includes a contact surface adapted for an electrical connection with the external part.

6. The cylinder body of claim 5, wherein the contact surface of the base portion is opposite with regard to the clipping portion and includes a connection pin.

7. A spring-loaded contact including:
- a cylinder body according to any of claims 1 to 6;
- a piston body adapted to be electrically connected with another external part and including a shaft extending from the piston body,
wherein the shaft is mated with the clipping portion.

8. The spring-loaded contact of claim 7, wherein the piston body and the cylinder body are moveable in translation and/or in rotation one with regard to the other.

9. The spring-loaded contact of claim 8, wherein the spring-loaded contact includes a coil spring surrounding the clipping portion and the shaft, the piston body and the cylinder body being moveable in translation one with regard to the other and defining:
• an extended position in which the piston body is at a first distance of the cylinder body, and
• a compressed position in which the piston body is at a second distance, smaller than the first distance, of the cylinder body;
wherein 10% to 15% of the shaft length is accommodated in the clipping portion in the extended position and 90 to 99% of the shaft length is accommodated in the clipping portion in the compressed position.

10. The spring-loaded contact of any of claims 7 to 9, wherein the piston body includes a contact surface adapted for an electrical connection with the other external part.

11. The spring-loaded contact of claim 10, wherein the contact surface of the piston body is opposite with regard to the shaft and includes a connection pin.

12. The spring-loaded contact of any of claims 7 to 11, including a case accommodating the cylinder body and the piston body and defining a first opening allowing a connection of the base portion with the external part and a second opening allowing a connection of the piston body with the another external part.

13. An electrical or electronic system including a spring-loaded contact according to any of claims 7 to 12.

14. A manufacturing method of a spring-loaded contact according to claim 12, including:
- Providing the cylinder body, the piston body, the coil spring and the case;
- Introducing one of the piston body and the cylinder body in the case through the first opening;
- Introducing the coil spring in the case through the first opening;
- Introducing the other of the piston body and the cylinder body in the case through the first opening and closing the first opening with the other of the piston body and the cylinder body.

15. Use of a spring-loaded contact according to any of claims 7 to 12 in order to transmit electrical power or electrical signals in an electrical system or electronic system.
